# EUROPÄISCHE PATENTANMELDUNG

(11) **EP 2 463 914 A1**
(43) Veröffentlichungstag der Anmeldung: **13.06.2012**
(21) Anmeldenummer: 11075267.2
(22) Anmeldetag: 06.12.2011
(51) Int. Cl.: H01L 31/02, H01L 31/048

(54) **Sicherheitseinrichtung für Photovoltaikanlagen**

(30) Priorität: 07.12.2010 DE 102010062539
(71) Anmelder: HST Elektronik GmbH, 47799 Krefeld (DE)
(72) Erfinder: Stecker, Rüdger, 41352 Korschenbroich (DE)
(74) Vertreter: Schubert, Klemens

(57) **Zusammenfassung**

Die Erfindung betrifft eine Sicherheitseinrichtung für eine aus mindestens einer, vorzugsweise mehreren Solarzellen (5011 - 501 n) mit jeweils einer Anschlussbox (502) bestehende Photovoltaikanlage. Die Sicherheitseinrichtung besteht mindestens aus jeweils einer Sicherheitsschalteinheit (100) je Solarzellenmodul (500) und aus mindestens einer Zentraleinheit (200), wobei jede Sicherheitsschalteinheit (100) mit einer Zentraleinheit (200) in Verbindung steht. Die Sicherheitsschalteinheiten (100) sind in die Anschlussbox (502) eines jeweiligen Solarzellenmoduls (500) integriert oder als Aufsteckmodul ausgebildet. Jede Sicherheitsschalteinheit (100) kann mindestens einen Schaltzustand einnehmen, in dem das zugehörige Solarzellenmodul (500) unter spannungsmäßiger Auftrennung des Verbunds mit anderen Einheiten der Photovoltaikanlage überbrückt ist.

Die jeweilige Sicherheitsschalteinheit (100) wird zur Einnahme eines den Verbund des zugehörigen Solarzellenmoduls (500) mit anderen Einheiten der Photovoltaikanlage spannungsmäßig auftrennenden Schaltzustandes durch die mit ihr in Verbindung stehende Zentraleinheit (200) veranlasst und/oder sie signalisiert der Zentraleinheit (200) die Einnahme dieses Schaltzustandes über die bestehende Verbindung.

## Beschreibung

Die Erfindung betrifft eine Sicherheitseinrichtung für Photovoltaikanlagen, welche es insbesondere ermöglicht, eine Photovoltaikanlage teilweise oder vollständig spannungs- und erforderlichenfalls stromfrei zu schalten. Die Sicherheitseinrichtung ist gleichermaßen für aus monokristallinen Solarzellen, aus polykristallinen Solarzellen und aus Dünnschichtzellen bestehende Photovoltaikanlagen verwendbar.

Photovoltaikanlagen, wie sie gegenwärtig vermehrt auf Dächern von Gebäuden zur Erzeugung von Strom für den Eigenbedarf und/oder zur Einspeisung in das öffentliche Stromnetz installiert werden, bestehen aus einer größeren Zahl von Solarzellen, die in intelligenter Weise miteinander verschaltet sind, um einerseits die zur Nutzung oder Einspeisung des erzeugten Solarstroms erforderlichen Spannungs- und Stromwerte zur Verfügung zu stellen und andererseits einen möglichst störungsfreien Betrieb der Anlage zu gewährleisten. Dabei werden mehrere der jeweils eine Spannung von 0,5 V bis 0,7 V zur Verfügung stellenden Solarzellen in Reihe geschaltet. Demgemäß wird von beispielsweise 92 in Reihe geschalteten Solarzellen eine Spannung von ca. 64 V zur Verfügung gestellt. Aufgrund der Reihenschaltung der Solarzellen würden jedoch der Ausfall nur einer Solarzelle oder eine an irgendeiner Stelle dieser Reihenschaltung auftretende Unterbrechung den Ausfall des kompletten Solarzellenmoduls zur Folge haben. Um dies zu verhindern, ist es üblich, die in Reihe geschalteten Solarzellen eines Solarzellenmoduls in mehrere Substrings zu unterteilen, welche in einer auch als Junction-Box bezeichneten Anschlussbox zusammengeführt sind, in der zu jedem Substring eine Bypassdiode parallel geschaltet ist. Hierdurch wird erreicht, dass beispielsweise beim Ausfall einer Solarzelle der betreffende Substring durch die Bypassdiode überbrückt wird und dadurch nicht das gesamte Solarzellenmodul ausfällt. Mehrere der in der vorgenannten Weise miteinander verschalteten Substrings bilden gemeinsam mit der zugehörigen Junction-Box ein Solarzellenmodul aus, durch welches beispielsweise die vorstehend bereits genannte Spannung von ca. 64 V zur Verfügung gestellt wird. Innerhalb einer Photovoltaikanlage wiederum sind mehrere derartiger Solarzellenmodule in Reihe geschaltet oder in einer gemischten Reihen- und Parallelschaltung an einem Wechselrichter ausgangs der Anlage zusammengeführt, durch welchen eine Wandlung von Spannung und Strom in die für das Wechselstromnetz erforderliche Form erfolgt. Dabei bilden mehrere in Reihe miteinander verschaltete Module einen so genannten String aus, wobei im Hinblick auf die schon erwähnte gemischte Reihen- und Parallelschaltung von Solarzellenmodulen in der Regel mehrere solcher Strings parallel geschaltet und in dem Wechselrichter zusammengeführt beziehungsweise innerhalb des Wechselrichters parallel geschaltet sind.

Bereits seit Längerem ist es bekannt, dass die zuvor erläuterte Verschaltung der jeweils aus mehreren Solarzellen bestehenden Solarzellenmodule in der Praxis teilweise Probleme verursacht und darüber hinaus in bestimmten Situationen sogar zu nicht unerheblichen Gefahren führt. So ist es beispielsweise zur Durchführung von Wartungsarbeiten an einer Photovoltaikanlage aus Sicherheitsgründen erforderlich, die gesamte Anlage abzuschalten. Insoweit gilt es zu bedenken, dass an einem aus mehreren Solarzellenmodulen bestehenden String bei entsprechender Lichteinstrahlung eine Spannung von mehreren 100 V bis 1.000 V anliegt. Gleichzeitig liefert ein entsprechender String einen Strom von mehreren Ampere, das heißt von gegebenenfalls ca. 6 A oder mehr. Bedenkt man auf der anderen Seite, dass bereits Gleichspannungen von 120 V bei einem Strom von 0,05 A tödlich sein können, so wird klar, dass eine Wartung einer voll in Betrieb befindlichen Anlage aus Gründen des Arbeitsschutzes zumindest riskant ist und vorzugsweise unterbleiben sollte. Nach dem Stand der Technik erfolgt die Abschaltung einer Photovoltaikanlage im Allgemeinen in der Nähe des bereits erwähnten Wechselrichters, durch Auftrennung der jeweiligen Verbindung der Strings mit dem Wechselrichter. Abgesehen davon, dass sich entsprechende Abschalteinrichtungen häufig innerhalb der Gebäude befinden, was beispielsweise bei Abwesenheit der Hausbewohner im Brandfall für sich genommen schon problematisch sein kann, wird aber außerdem auch bei aufgetrennter Verbindung zwischen den Strings und dem Wechselrichter in den Solarzellenmodulen eine Spannung erzeugt, sofern die Solarzellenmodule weiterhin dem Licht ausgesetzt sind. Ausgangs der Strings aber auch an den einzelnen Modulen stehen mithin teilweise weiterhin hohe Spannungen an, wobei bei einem Berühren entsprechender spannungsführender Teile beträchtliche Ströme fließen können. Dies hat jedoch zur Konsequenz, dass beispielsweise im Falle eines Brandes, es nicht ohne Weiteres möglich ist, alle Teile und Bereiche der Photovoltaikanlage spannungsfrei zu schalten. Hieraus ergibt sich die Konsequenz, dass der Einsatz von Löschwasser zur Bekämpfung des Brandes problematisch ist, da aufgrund der zumindest bei Tageslicht an den Solarzellenmodulen und Strings anstehenden hohen Spannungswerte eine akute Gefahr für die Feuerwehrleute und die Umgebung besteht. Aber auch in der Nacht können an den Solarzellenmodulen, beispielsweise durch eine eventuell von der Feuerwehr während der Löscharbeiten verwendete Einsatzbeleuchtung oder unter Umständen auch durch den Lichtschein eines Feuers selbst, Spannungen anstehen, so dass das Löschen eines mit einer Photovoltaikanlage ausgestatteten Hauses möglicherweise behindert wird. Zwar gibt es bereits spezielle Löschdüsen, welche das Wasser so fein vernebeln, dass ein die entsprechende Löscheinrichtung betätigender Feuermann durch das Wasser unmittelbar nicht gefährdet wird. Jedoch stellt beispielsweise sich in Kellern sammelndes Wasser ebenfalls ein Sicherheitsrisiko dar, wenn, wie durchaus üblich, Anlagenteile wie zum Beispiel der Wechselrichter hier angeordnet sind. Bei den Feuerwehren gibt es daher teilweise die Anordnung, in einem solchen Falle das betroffene Haus kontrolliert abbrennen zu lassen. Dies ist aber aufgrund der mit einem Brand verbundenen Gefahren und der Vernichtung von Eigentums- beziehungsweise Vermögenswerten selbstverständlich nicht wünschenswert.

Aufgabe der Erfindung ist es daher, eine Sicherheitseinrichtung zur Verfügung zu stellen, welche die vorgenannten Nachteile vermeidet. Die dafür zu schaffende Sicherheitseinrichtung soll es insbesondere ermöglichen, an einer Photovoltaikanlage während des Betriebes Wartungsarbeiten vorzunehmen und im Falle eines Brandes den Einsatz von Löschwasser zuzulassen, ohne dass hierdurch Personen gefährdet werden. Vorzugsweise soll die erfindungsgemäße Einrichtung im Hinblick auf ihre Bezeichnung als Sicherheitseinrichtung nicht nur dazu geeignet sein, Gefahren für Wartungstechniker oder Feuerwehrleute auszuschließen. Sie soll vielmehr Sicherheit auch insoweit gewährleisten, als durch sie ein zuverlässiger und weitgehend störungsfreier Betrieb einer mit ihr ausgestatteten Photovoltaikanlage gewährleistet wird und gegebenenfalls erforderliche Instandhaltungs- und Instandsetzungsmaßnehmen gefahrlos ermöglicht werden.

Die Aufgabe wird durch eine Sicherheitseinrichtung mit den Merkmalen des Patentanspruchs 1 gelöst. Vorteilhafte Aus- beziehungsweise Weiterbildungen der Erfindung sind durch die Unteransprüche gegeben.

Eine die Aufgabe lösende Sicherheitseinrichtung ist konzipiert für den Einsatz in einer Photovoltaikanlage, die mindestens ein aus einer Mehrzahl von Solarzellen und einer Anschlussbox bestehendes Solarzellenmodul aufweist, welches über seine Anschlussbox mit mindestens einer anderen Einheit der Photovoltaikanlage verbunden ist. Nach diesem Verständnis handelt es sich bei der vorgenannten anderen Einheit der Photovoltaikanlagen vorzugsweise um ein weiteres Solarzellenmodul gleicher Ausbildung. Im Hinblick darauf, dass bei in der Praxis anzutreffenden Photovoltaikanlagen regelmäßig eine Mehrzahl von Solarzellenmodulen in einer gemischten Reihen- und Parallelschaltung miteinander verschaltet sind, wobei mehrere in Reihe geschaltete Solarzellenmodule einen String ausbilden und gegebenenfalls mehrere derartiger parallel geschalteter Strings an einem Knoten oder an beziehungsweise in einem Wechselrichter der Photovoltaikanlage zusammengeführt sind, kann es sich aber bei der besagten anderen Einheit beispielsweise auch um den Wechselrichter handeln.

Unter Berücksichtigung der vorstehend dargestellten Beschaffenheit einer mit der Sicherheitseinrichtung ausgestatteten Photovoltaikanlage besteht die Sicherheitseinrichtung erfindungsgemäß mindestens aus jeweils einer Sicherheitsschalteinheit je Solarzellenmodul der Photovoltaikanlage und aus mindestens einer mit einer oder mehreren Sicherheitsschalteinheiten zumindest der betreffenden Photovoltaikanlage in einer Verbindung stehenden Zentraleinheit. Je nach Größe der Photovoltaikanlage können demgemäß auch mehrere gleich ausgebildete Zentraleinheiten vorhanden sein, von denen jede mit einer oder mehreren, jeweils einem Solarzellenmodul zugeordneten Sicherheitsschalteinheiten verbunden ist, wobei aber jedenfalls jede als Bestandteil der erfindungsgemäßen Sicherheitseinrichtung vorgesehene Sicherheitsschalteinheit mit genau einer Zentraleinheit interagiert. Denkbar ist es dabei auch, dass eine Zentraleinheit mit Sicherheitsschalteinheiten mehrerer Photovoltaikanlagen benachbart stehender Häuser beziehungsweise Gebäude verbunden ist. Zu den Möglichkeiten der konkreten Ausbildung einer entsprechenden Zentraleinheit sollen Ausführungen an späterer Stelle, insbesondere auch im Zusammenhang mit der Erläuterung eines Ausführungsbeispiels erfolgen. An dieser Stelle sei lediglich angemerkt, dass es sich insoweit im Hinblick auf die Funktion um eine Einheit, also um eine Funktionseinheit handelt, deren Bestandteile aber nicht notwendigerweise auch als körperliche beziehungsweise integrale Einheit zusammengefasst sein müssen. Die einem jeden Solarzellenmodul jeweils zugeordnete Sicherheitsschalteinheit ist erfindungsgemäß entweder in die Anschlussbox des jeweiligen Solarzellenmoduls integriert oder als Aufsteckmodul ausgebildet, welches in die Verbindung der betreffenden Anschlussbox mit der mindestens einen anderen Einheit der Photovoltaikanlage einschleifbar ist, mit welcher das zugehörige Solarzellenmodul verbunden ist. Jede der zur erfindungsgemäßen Sicherheitseinrichtung gehörenden Sicherheitsschalteinheiten ist so ausgebildet, dass sie mehrere Schaltzustände einnehmen kann, wobei in mindestens einem dieser Schaltzustände das zugehörige Solarzellenmodul unter spannungsmäßiger Auftrennung des Verbundes mit anderen Einheiten der Photovoltaikanlage überbrückt ist. Selbstverständlich bleibt hierbei jedoch die Verbindung der Sicherheitsschalteinheit mit der Zentraleinheit bestehen. Insoweit bezieht sich das Auftrennen des Verbundes eines Solarzellenmoduls mit anderen Einheiten der Photovoltaikanlage darauf, dass das Solarzellenmodul aufgrund dessen, dass es durch die zugehörige Sicherheitsschalteinheit gebrückt beziehungsweise überbrückt wird, nur spannungsmäßig von den übrigen Einheiten der Photovoltaikanlage entkoppelt wird, so dass seine Klemmspannung nicht zu der von der Anlage insgesamt bereitgestellten Spannung beiträgt. Hingegen bleibt der Verbund des betreffenden Solarzellenmoduls, genauer gesagt seine galvanische Verbindung, mit der oder den anderen Einheiten der Photovoltaikanlage aufgrund der angesprochenen Überbrückung bezogen auf den Strom erhalten. Im Falle mehrerer in Reihe geschalteter, also zu einem String verbundener Solarzellenmodule bedeutet dies, dass auch bei einer mittels der erfindungsgemäßen Anordnung realisierten spannungsmäßigen Heraustrennung eines Solarzellenmoduls aus dem String weiterhin ein Stringstrom fließen kann. Unabhängig davon bleibt zudem, wie bereits ausgeführt, die Verbindung der zu dem betreffenden Solarzellenmodul gehörenden Sicherheitsschalteinheit mit der ihr zugeordneten Zentraleinheit erhalten.

Demnach handelt es sich bei dem erfindungsgemäß entsprechend einem Schaltzustand seiner Sicherheitsschalteinheit vorgesehenen spannungsmäßigen Herauslösen und Überbrücken eines Solarzellenmoduls nicht um einen Kurzschluss, wie er beispielsweise bei einer Überbrückung des Solarzellenmoduls mittels eines Drahtes beziehungsweise der Ader eines Kabels gegeben wäre. Ein solcher Kurzschluss käme schon wegen des in diesem Falle bei einem weiterhin dem Licht ausgesetzten Solarzellenmodul entstehenden hohen Kurzschlussstroms nicht in Betracht.

Je nach der Beschaffenheit der Zentraleinheit oder Zentraleinheiten einerseits und der Sicherheitsschalteinheit beziehungsweise Sicherheitsschalteinheiten andererseits sowie in Abhängigkeit der Konfiguration der vorgenannten Einheiten und ihrer Betriebsweise wird die erfindungsgemäß zwischen der oder den Sicherheitsschalteinheiten und der jeweils zugehörigen Zentraleinheit bestehende Verbindung für unterschiedliche Zwecke genutzt. Entsprechend einer vorgesehenen Möglichkeit wird dabei eine jeweilige Sicherheitsschalteinheit zur Einnahme des Schaltzustandes, in welchem sie das zugehörige Solarzellenmodul spannungsmäßig von den anderen Einheiten der Photovoltaikanlage trennt, durch die zugehörige Zentraleinheit, beispielsweise aufgrund einer entsprechenden Bedienung, veranlasst. Sofern die Sicherheitseinrichtung jedoch nur zur Trennung eines oder mehrerer Solarzellenmodule von den anderen Einheiten der Photovoltaikanlage bei einem eintretenden Notfall konfiguriert ist, ist es aber auch denkbar, dass die Trennung eines jeweiligen Solarzellenmoduls durch die zugehörige Sicherheitsschalteinheit selbst veranlasst wird und diese der entsprechenden Zentraleinheit lediglich die Einnahme dieses Schaltzustandes über die bestehende Verbindung signalisiert. So kann es beispielsweise vorgesehen sein, dass eine solche Selbstabschaltung erfolgt, sofern eine Sicherheitsschalteinheit etwa auf dreimalige Anfrage von der Zentraleinheit keine Antwort erhält. In diesem Falle sendet die Sicherheitsschalteinheit nach der Abschaltung des zugehörigen Solarzellenmoduls zyklisch eine Störungsmeldung an die Zentraleinheit, welche von letzterer gegebenenfalls auch über das Internet weitergeleitet werden kann, um beispielsweise eventuell den Betreiber der Photovoltaikanlage oder einen Servicetechniker beziehungsweise ein Serviceteam über die bestehende Störung zu informieren. Darüber hinaus ist aber selbstverständlich auch die Kombination der beiden zuvor dargestellten Möglichkeiten denkbar, wonach beispielsweise je nach Ereignis oder Grund die spannungsmäßige Trennung eines Solarzellenmoduls von den übrigen Einheiten der Photovoltaikanlage wahlweise durch die Zentraleinheit oder die zum Solarzellenmodul gehörende Sicherheitsschalteinheit veranlasst wird und darüber hinaus die Einnahme des entsprechenden Schaltzustandes durch die Sicherheitsschalteinheit an die zugehörige Zentraleinheit signalisiert wird.

Zur Verbindung der Sicherheitsschalteinheiten mit der Zentraleinheit kommen erfindungsgemäß unterschiedliche Möglichkeiten in Betracht. Demgemäß kann diese Verbindung beispielsweise als eine Funkverbindung ausgebildet sein, wobei ein funkgestützter Datenaustausch zwischen den Sicherheitsschalteinheiten mit der Zentraleinheit vorzugsweise in einem ISM-Band (Industrial, Scientific and Medical Band) mit einer Trägerfrequenz von 433 MHz, 868 MHz, 2,4 GHz oder 5 GHz erfolgt. Die Funkverbindung kann aber auch im Rahmen eines WLAN bestehen, in welches zumindest die Sicherheitsschalteinheit oder Sicherheitsschalteinheiten und die Zentraleinheit einbezogen sind. Denkbar ist jedoch auch eine drahtgebundene Verbindung oder eine Verbindung über Lichtwellenleiter, wobei die Verbindung hierbei durch die Ankopplung an einen mehrere Sicherheitsschalteinheiten untereinander und mit der zugehörigen Zentraleinheit verbindenden elektrischen oder optischen Bus erfolgt, über den die Sicherheitsschalteinheiten von der Zentraleinheit beziehungsweise die Zentraleinheit von den Sicherheitsschalteinheiten durch eine binäre Adressierung angesprochen werden. Im Falle der Verbindung der Einheiten der erfindungsgemäßen Sicherheitseinrichtung über einen Bus ist es dabei besonders bevorzugt, wenn der Bus als ein Ringbus ausgebildet ist, Entsprechend einer bevorzugten Ausgestaltung der Erfindung sind die Sicherheitsschalteinheit oder Sicherheitsschalteinheiten so ausgebildet, dass sie die zu ihrem Betrieb erforderlichen Spannungswerte aus der vom zugehörigen Solarzellenmodul bereitgestellten Spannung gewinnen. Eine entsprechende Ausbildungsform der erfindungsgemäßen Sicherheitseinrichtung ist vorteilhaft noch dadurch weitergebildet, dass die Sicherheitsschalteinheit oder Sicherheitsschalteinheiten über mindestens einen Speicherkondensator verfügen, durch welchen die zum Betrieb der jeweiligen Sicherheitsschalteinheit genutzte Spannung des zugehörigen Solarzellenmoduls gepuffert wird, so dass die betreffende Sicherheitsschalteinheit über einen gewissen Zeitraum hinweg auch ohne Solarenergie, das heißt ohne Bereitstellung einer entsprechenden Spannung durch das zugehörige Solarzellenmodul, betrieben werden kann.

Im Hinblick auf die schon erwähnte Möglichkeit einer Konfiguration, bei welcher ein Solarzellenmodul von den übrigen Einheiten der Photovoltaikanlage spannungsmäßig dadurch getrennt wird, dass die zugehörige Sicherheitsschalteinheit den erforderlichen Schaltzustand selbsttätig einnimmt, umfassen die Sicherheitsschalteinheit oder Sicherheitsschalteinheiten gemäß einer bevorzugten Weiterbildung der Erfindung eine oder mehrere Prüf- und Messkomponenten zur Messung und/oder Überwachung von zumindest Strom- und Spannungswerten ihres zugehörigen Solarzellenmoduls. Die Messdaten der betreffenden Prüf- und Messkomponenten werden dabei außerdem an die mit ihnen verbundene Zentraleinheit übermittelt. Die Messdaten können hierbei beispielsweise als Rohdaten an die Zentraleinheit übermittelt werden. Vorzugsweise verfügen jedoch die Sicherheitsschalteinheit oder Sicherheitsschalteinheiten über einen eigenen Prozessor oder Mikrocontroller, durch den eine Vorverarbeitung beziehungsweise Aufbereitung der Messdaten erfolgt und die vorverarbeiteten Messdaten nach einem standardisierten Datenprotokoll an die Zentraleinheit übertragen werden.

Darüber hinaus können die Sicherheitsschalteinheit oder Sicherheitsschalteinheiten außerdem mit Prüf- und Messkomponenten beziehungsweise Schaltungsteilen ausgestattet sein, durch welche neben Strom- und Spannungswerten weitere Messwerte am jeweiligen Solarzellenmodul oder dessen Umgebung erfasst werden, wie beispielsweise die Solarzellentemperatur oder die Umgebungstemperatur. Letzteres ermöglicht unter Umständen auch die Früherkennung einer bestehenden Brandgefahr und eine Reaktion hierauf durch Abschalten der Anlage oder von Anlagenteilen. Vorzugsweise werden Daten zu den mittels entsprechender Sensoren gemessenen Temperaturen außerdem an die zugehörige Zentraleinheit übertragen und dort protokolliert. Besonders bevorzugt ist es dabei, wenn entsprechende Prüf- und Messkomponenten zur Temperaturmessung über eine gesonderte serielle Busleitung mit der Zentraleinheit verbunden sind, wobei die entsprechenden Prüf- und Messkomponenten der einzelnen Solarzellenmodule vorzugsweise durch Adressierung mit einer Binäradresse unterschieden werden. Bei einer vorgesehenen entsprechend ausgebildeten Ausführungsform der Erfindung werden in besonders vorteilhafter Weise über einen solchen Bus gleichermaßen Adressierungsdaten für die Temperatursensoren beziehungsweise für Empfänger von Messdaten wie auch die Messdaten selbst bidirektional übertragen und außerdem die Messkomponente zur Temperaturmessung mit Spannung versorgt. Im Falle einer Übermittlung der Daten in Form von Datenprotokollen wird vorzugsweise neben den eigentlichen Messwerten ein Zeitstempel mit Datum und Uhrzeit der jeweiligen Messung an die zugehörige Zentraleinheit übertragen. Auf der Grundlage dieser Angaben können beispielsweise Log-Protokolle zum Betrieb von Solarzellenmodulen erstellt werden, wobei die Daten der einzelnen Solarzellenmodule vorzugsweise durch eine von der ihnen jeweils zugeordneten Sicherheitsschalteinheit an die betreffende Zentraleinheit mit übertragene ID unterschieden werden.

Entsprechend einer besonders bevorzugten Ausbildungsform der Erfindung wird durch eine Zentraleinheit zeitversetzt ein zyklischer Test der einzelnen Solarzellenmodule veranlasst, bei welchem Strom- und Spannungswerte und gegebenenfalls weitere Messwerte, wie Innenwiderstand oder Temperatur, sowohl im Normalbetrieb, das heißt unter Last, als auch im Leerlauffall, erfasst werden. Über die Durchführung wiederholter Tests können im Wege einer impulsmäßigen Belastung eines jeweiligen Solarzellenmoduls beispielsweise Beschädigungen, das Auftreten von Alterungserscheinungen, welche die Funktionstüchtigkeit der Anlage bedrohen, oder das Erforderlichwerden von Wartungsarbeiten erkannt werden. Entsprechende Tests können wiederholt manuell oder, wie bereits ausgeführt, vorzugsweise initiiert durch die Zentraleinheit automatisch veranlasst werden. Im Hinblick auf den Datenaustausch zwischen den Sicherheitsschalteinheiten einzelner von mehreren Solarzellenmodulen und einer Zentraleinheit ist die erfindungsgemäße Sicherheitseinrichtung zudem vorzugsweise so ausgebildet beziehungsweise konfigurierbar, dass sie sich und ihre Funktion gewissermaßen selbst überwacht. So kann es vorgesehen sein, dass die Zentraleinheit in einer Protokollbeziehungsweise Log-Datei einen Eintrag erstellt, wenn eine Sicherheitsschalteinheit für längere Zeit oder mehrmals nicht ansprechbar ist oder sich über einen festgelegten Zeitraum nicht zur Übertragung von Messdaten bei der Zentraleinheit gemeldet hat. Darüber hinaus kann dazu von der Zentraleinheit eine Meldung an eine übergeordnete Stelle, wie einen Betreiber oder ein Servicecenter, abgesetzt werden. Zum Zwecke eines solchen Eintrags, aber insbesondere des Absetzens einer Meldung an eine gegebenenfalls mehrere Photovoltaikanlagen betreibende und/oder technisch betreuende Stelle werden mehrere Sicherheitsschalteinheiten über die schon erwähnte ID unterschieden, welche zum Beispiel eine Gebäudeadresse (zur Bestimmung des jeweiligen mit der insoweit überwachten Photovoltaikanlage ausgestatteten Gebäudes) und eine Geräteadresse (zur Bestimmung der konkret betroffenen Sicherheitsschalteinheit) enthält oder verschlüsselt. Daneben umfasst die Selbstüberwachung der Sicherheitseinrichtung gegebenenfalls auch die schon erwähnte Störmeldung, welche eine Sicherheitsschalteinheit im Falle des Ausbleibens einer Antwort der Zentraleinheit zyklisch aussendet.

Die Sicherheitsschalteinheit oder Sicherheitsschalteinheiten der erfindungsgemäßen Sicherheitseinrichtung können vorteilhaft noch dadurch weitergebildet sein, dass durch sie das zugehörige Solarzellenmodul im Falle seiner spannungsmäßigen Trennung von den übrigen Einheiten der Photovoltaikanlage sicherheitshalber zusätzlich kurzgeschlossen wird, so dass die bei Lichteinfall weiterhin am Ausgang des jeweiligen Solarzellenmoduls beziehungsweise an den Klemmen seiner Anschlussbox anstehende, zwar im allgemeinen für sich noch nicht lebensgefährliche Spannung kurzgeschlossen wird. Ferner kann die Sicherheitseinrichtung noch durch zusätzliche, ebenfalls mit einer entsprechenden Zentraleinheit verbundene Kurzschluss-Schalteinheiten erweitert sein, welche im Gefahrenfalle oder bei Wartungsarbeiten einen durch jeweils mehrere in Reihe geschaltete Solarzellenmodule gebildeten String kurzschließen. Hierdurch ist es möglich, gewissermaßen als zusätzliche Sicherheitsmaßnahme einen String vorsorglich auch dann kurzzuschließen, wenn an den Enden des betreffenden Strings keine Spannung ansteht, weil bereits alle Solarzellenmodule mittels der zugehörigen Sicherheitsschalteinheit überbrückt und damit eigentlich spannungsmäßig von dem betreffenden String getrennt sind.

Vorzugsweise weisen die Zentraleinheit oder Zentraleinheiten der erfindungsgemäßen Sicherheitseinrichtung einen Nottaster auf. Bei dessen Betätigung werden alle zugehörigen Solarzellenmodule aus dem Verbund mit anderen Einheiten der Photovoltaikanlage getrennt, also spannungsmäßig von den übrigen Einheiten der Photovoltaikanlage entkoppelt. Insbesondere bei dieser Ausbildungsform ist es vorgesehen, die gegebenenfalls noch innerhalb der einzelnen Solarzellenmodule entstehenden Spannungen kurzzuschließen, wofür die den Solarzellenmodulen jeweils zugeordneten Sicherheitsschalteinheiten entsprechend ausgebildet sind. Vorzugsweise wird darüber hinaus, wie schon erläutert, zusätzlich und gewissermaßen zur Gewährleistung doppelter Sicherheit jeder durch mehrere Solarzellenmodule gebildete String jeweils durch die zuvor erwähnte Kurzschluss-Schalteinheit kurzgeschlossen, welche ebenfalls mit der Zentraleinheit in Verbindung steht.

Neben dem Nottaster verfügen die Zentraleinheit oder Zentraleinheiten über weitere Bedienmittel zu ihrer Steuerung und Konfiguration. Hierbei sind unterschiedliche Konstellationen denkbar. Beispielsweise kann die entsprechende Zentraleinheit durch einen handelsüblichen PC ausgebildet sein, durch welchen eine Software verarbeitet wird, welche die Steuerung und/oder Konfiguration der Zentraleinheit mittels Tastatur und/oder Maus und Bildschirm ermöglicht. Alternativ dazu oder zusätzlich kann aber auch eine gesonderte, einfache Tastatur beziehungsweise ein Bedienfeld vorgesehen sein, welches die Bedienung einer Zentraleinheit und damit auch der mit ihr verbundenen Sicherheitsschalteinheiten und gegebenenfalls zusätzlichen Kurzschluss-Schalteinheiten durch Betätigung einfacher Tasten mit fest zugeordneter Funktion ermöglicht. Eine solche gesonderte Tastatur ist vorzugsweise, ebenso wie der Notschalter, als von der entsprechenden Zentraleinheit abgesetzte Einheit ausgebildet. Der Notschalter kann dabei beispielsweise an der Außenwand eines Gebäudes angeordnet oder in anderer Weise zumindest für die Feuerwehr stets zugänglich angeordnet sein. Er kann beispielsweise innerhalb eines Gehäuses untergebracht sein, für welches die Feuerwehr einen gesonderten Generalschlüssel besitzt.

In Weiterbildung der Erfindung sind die Zentraleinheit oder Zentraleinheiten darüber hinaus mit einer Internetzugangseinrichtung ausgestattet und über das Internet von entfernter Stelle (beispielsweise von einer Feuerwehrwache oder einem Servicedienst) steuerbar und/oder konfigurierbar. Darüber hinaus ist eine entsprechende Zentraleinheit mit unterschiedlichen Ausgabemitteln und - komponenten verbunden beziehungsweise gekoppelt, die je nach ihrer Art vor Ort, also an einem mit der erfindungsgemäß ausgestatteten Photovoltaikanlagen ausgerüsteten Gebäude, oder an entfernter Stelle angeordnet sein können. Zu nennen sind hierbei beispielsweise ein optischer und/oder akustischer Alarm, durch den gravierende Fehlfunktionen der Anlage, welche mittels der vorzugsweise vorgesehenen Mess- und Prüfkomponenten festgestellt werden, oder Gefahrensituationen signalisiert werden. Darüber hinaus können als Ausgabekomponenten ein Funksignalgeber, durch welchen die Ausgabe eines optischen und/oder akustischen Signals an entfernter Stelle initiiert wird, eine leitungsgebundene Aufschaltung bei der Feuerwehr oder über das Internet angesprochene Ausgabekomponenten an entfernter Stelle vorgesehen sein. Ferner sind die Zentraleinheit oder Zentraleinheiten vorzugsweise mit einem USB-Anschluss ausgestattet, welcher dem Anschluss eines speziellen USB-Funkmoduls zum Auslesen von zu den Solarzellenmodulen in der Zentraleinheit gespeicherten Daten für deren Übertragung auf den Laptop eines Servicetechnikers oder an eine zentrale Stelle dient.

Nachfolgend sollen Details der Erfindung anhand eines Ausführungsbeispiels erläutert werden. In den zugehörigen Zeichnungen zeigen:

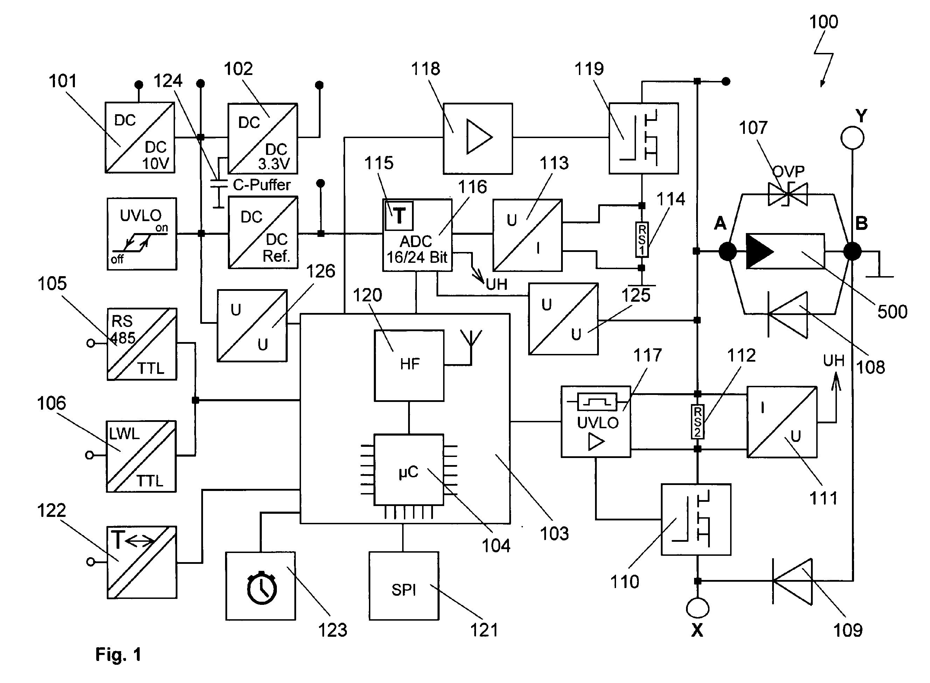

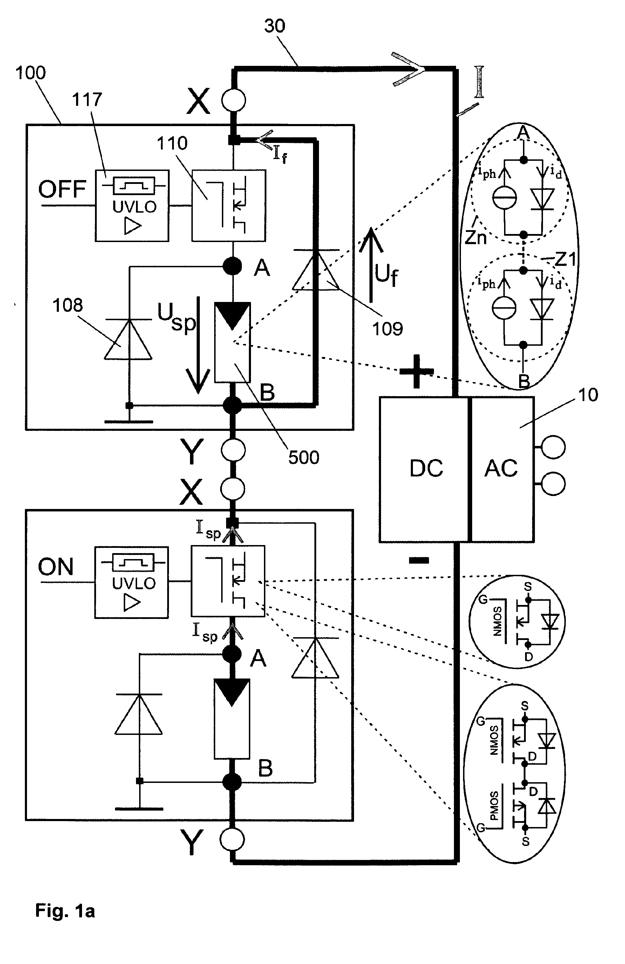

- Fig. 1:: ein mit einer im Blockschaltbild dargestellten Sicherheitsschalteinheit beschaltetes Solarzellenmodul als Teil der erfindungsgemäßen Sicherheitseinrichtung,
- Fig. 1 a:: ein vereinfachtes Blockschaltbild des in der Fig. 1 gezeigten Teils der Sicherheitseinrichtung in seiner Einordnung in einen String mit einem in gleicher Weise mit einer Sicherheitsschalteinheit beschalteten weiteren Solarzellenmodul,
- Fig. 2:: die Prinzipdarstellung eines Solarzellenmoduls,
- Fig. 3:: ein Blockschaltbild einer möglichen Ausbildungsform der Zentraleinheit,
- Fig. 4:: die Prinzipdarstellung einer Photovoltaikanlage mit mehreren zu Strings zusammengefassten Solarzellenmodulen und diesen zugeordneten Sicherheitsschalteinheiten,
- Fig. 5:: ein Blockschaltbild einer Kurzschluss-Schalteinheit zum Kurzschließen eines Strings,
- Fig. 6:: die Topologie für ein zentrales, die Zentraleinheit einbeziehendes System,
- Fig. 7:: ein Blockschaltbild eines USB-Funkmoduls.

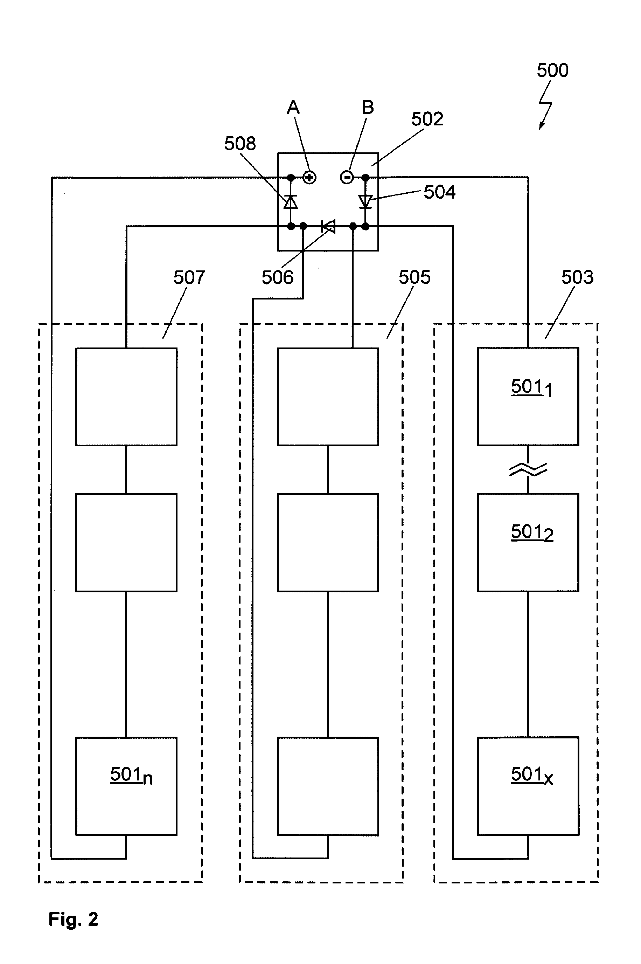

In der Fig. 1 ist ein mit einer Sicherheitsschalteinheit 100 beschaltetes Solarzellenmodul 500 als Teil der erfindungsgemäßen Sicherheitseinrichtung für eine Photovoltaikanlage mit mehreren in einem oder mehreren Strings angeordneten Solarzellenmodulen dargestellt. Die Figur zeigt ein Blockschaltbild für eine mögliche Ausbildungsform einer solchen, auch als SSUP (Solarzellen-Sicherheitsbeschaltung und Prüfeinrichtung) bezeichneten Sicherheitsschalteinheit 100 für ein Solarzellenmodul 500. Die entsprechende Sicherheitsschalteinheit 100, deren Blockschaltbild nachfolgend nur in groben Zügen erläutert werden soll, ist vorzugsweise zur Integration in die Anschlussbox 502 beziehungsweise Junction-Box (siehe Fig. 2) eines Solarzellenmoduls 500 vorgesehen (iSSUP = integrierte SSUP), kann aber in der dargestellten Ausbildungsform auch als Aufsteckmodul (eSSUP = externe SSUP) in die Verbindung der Anschlussbox 502 eines Solarzellenmoduls 500 mit anderen Einheiten einer Photovoltaikanlage eingeschleift werden. In diesem Zusammenhang ist in der Fig. 2 die Prinzipdarstellung eines Solarzellenmoduls 500 mit seiner Junction-Box beziehungsweise Anschlussbox 502 dargestellt. Demnach besteht ein Solarzellenmodul 500, wie es in der Praxis zusammen mit in gleicher Weise ausgebildeten anderen Solarzellenmodulen in einer Photovoltaikanlage zum Einsatz kommt, aus einer Mehrzahl innerhalb des Solarzellenmoduls 500 in Reihe geschalteter Solarzellen 501₁ - 501 ₙ. Jeweils eine Teilmenge der in dem Solarzellenmodul 500 in Reihe geschalteten Solarzellen 501₁ - 501ₙ ist zu einem Substring 503, 505, 507 zusammengefasst. Die in Reihe geschalteten Solarzellen 501₁ - 501ₙ liefern die an der Anschlussbox 502 abnehmbare Klemmspannung des Solarzellenmoduls 500, wobei innerhalb der Anschlussbox 502 für jeden in dem Solarzellenmodul 500 gebildeten Substring 503, 505, 507 eine Bypassdiode 504, 506, 508 angeordnet ist, welche den betreffenden Substring 503, 505, 507 im Falle des Ausfalls einer der in Reihe geschalteten Solarzellen 501₁ - 501ₙ beziehungsweise im Falle einer Unterbrechung innerhalb des Substrings 503, 505, 507 überbrückt und somit sicherstellt, dass nicht das gesamte Solarzellenmodul 500 ausfällt.

Die in der Fig. 1 in Form eines Blockschaltbildes gezeigte Sicherheitsschalteinheit 100 wird im Falle ihrer Integration unmittelbar an die Klemmpunkte A und B angeschlossen oder andernfalls zwischen diesen beiden Klemmpunkten eingeschleift. Mittels der Komponenten 101 und 102 werden aus der Klemmspannung des Solarzellenmoduls die für die Funktion der Sicherheitsschalteinheit 100 erforderlichen Versorgungsspannungen erzeugt, wobei die Komponente 102 außerdem durch einen Kondensator 124 gepuffert ist, welcher die Spannungsversorgung der Sicherheitsschalteinheit 100 auch dann für eine gewisse Zeit aufrechterhält, wenn beispielsweise das zugehörige Solarzellenmodul 500 verschattet ist oder aus einem sonstigen Grund keine adäquate Spannung bereitstellt. Wie aus dem Blockschaltbild ersichtlich, verfügt die dargestellte Sicherheitsschalteinheit 100 über einen Mikroprozessor beziehungsweise einen Mikrocontroller (µC) 104, welcher vorliegend als Teil eines Funkmoduls 103 ausgebildet ist, über welches die Sicherheitsschalteinheit 100 mit der Zentraleinheit 200 der erfindungsgemäßen Sicherheitseinrichtung in Verbindung steht. Darüber hinaus verfügt die Sicherheitsschalteinheit 100 aber auch noch über Schnittstellen 105, 106, mittels welcher sie zum Beispiel über einen elektrisch verdrahteten Bus oder über einen optischen Bus mit der Zentraleinheit 200 verbunden werden kann. Durch eine Überspannungsschutzeinrichtung 107 (Over-Voltage-Protection - OVP), welche parallel zu den Anschlusspunkten A und B geklemmt ist, werden eventuell auftretende kurzzeitige Spannungsspitzen über 80 V gekappt.

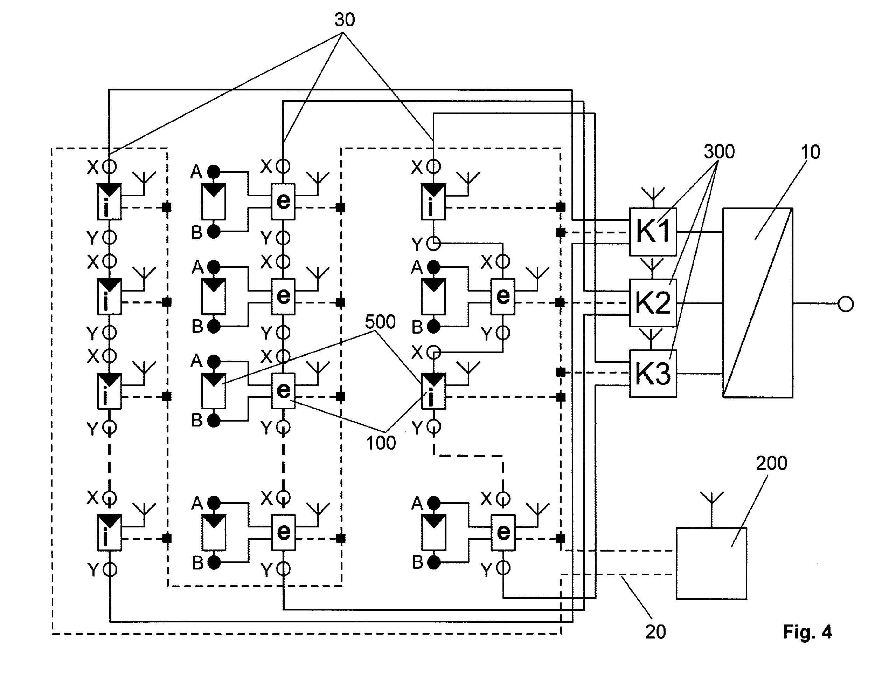

Als wesentliche Elemente der Sicherheitsschalteinheit sind insbesondere der MOSFET 110 und die Bypassdioden 108, 109 anzusehen. Der MOSFET 110, ein Leistungs-MOSFET, ist im Normalbetrieb, also bei eingeschaltetem und somit spannungsmäßig mit den übrigen Einheiten der Photovoltaikanlage gekoppeltem Solarzellenmodul 500 durchgeschaltet. Hierbei stellt die Bypassdiode 108 sicher, dass der zwischen den Punkten X, Y fließende Stringstrom, das heißt der Strom innerhalb eines Strings, in welches das entsprechende, mit der Sicherheitsschalteinheit 100 beschaltete Solarzellenmodul 500 einbezogen ist (siehe hierzu auch Fig. 1a und Fig. 4), auch dann weitergeleitet wird, wenn das betreffende Solarzellenmodul 500 verschattet ist oder innerhalb des Moduls eine Unterbrechung, gegeben ist. Beispielsweise wird der Stringstrom auch über diese Bypassdiode 108 geführt, wenn innerhalb der Anschlussbox 502 des Solarzellenmoduls 500 die Bypassdiode 504, 506, 508 eines der Substrings 503, 505, 507 defekt ist. Die Bypassdiode 109 sorgt für die Weiterleitung des Stringstroms, also des Stromes zwischen den Punkten X,Y im Falle dessen, dass das Solarzellenmodul 500 durch Sperren des MOSFET 110 spannungsmäßig aus dem Verbund mit anderen Einheiten der Photovoltaikanlage, insbesondere aus dem Verbund mit anderen in Reihe geschalteten Solarzellenmodulen herausgetrennt ist. Hierbei wird das Solarzellenmodul 500 durch diese Bypassdiode 109 überbrückt und der Stringstrom über die Bypassdiode 109 geleitet. In diesem Schalt- beziehungsweise Betriebszustand, bei dem das zugehörige Solarzellenmodul 500 durch die Sicherheitsschalteinrichtung 100 spannungsmäßig aus dem Verbund mit anderen Einheiten der Photovoltaikanlage herausgelöst ist, wird die gegebenenfalls aufgrund Lichteinfalls weiterhin in dem Solarzellenmodul entstehende Spannung durch eine Komponente 119, im gezeigten Beispiel ein weiterer MOSFET 119, kurzgeschlossen. Eine Sperrung des MOSFET 110 und damit ein spannungsmäßiges Herauslösen des mit der Sicherheitsschalteinheit 100 ausgestatteten Solarzellenmoduls 500 aus dem Verbund mit den anderen Einheiten der Photovoltaikanlage kann dabei zum Beispiel erfolgen aufgrund eines gewollten Abschaltens zu Wartungszwecken, bei am Solarzellenmodul 500 festgestellten Störungen, wie gefährlichen Überströmen oder Unterspannungen, welche die von der Anlage gelieferte Gesamtspannung beeinträchtigen. Darüber hinaus erfolgt eine solche Sperrung des MOSFET 110 temporär beziehungsweise kurzzeitig während eines erfindungsgemäß vorgesehenen Testbetriebs (Impulsbelastungsbetrieb) des Solarzellenmoduls 500, bei welchem Strom- und Spannungswerte sowie Innenwiderstand des Moduls unter definierten Lastbedingungen überprüft werden.

Mittels der Prüf- und Messkomponenten 111 und 112 werden der augenblickliche Stringstrom des mit der Sicherheitsschalteinheit 100 ausgestatteten Solarzellenmoduls sowie mit der Komponente 125 die Modulspannung im laufenden Betrieb überwacht, wobei die gemessenen Werte mittels des 16- oder 24-bitigen Analog-Digital-Wandlers 116 in über das Funkmodul 103 oder eine der anderen Schnittstellen 105, 106 an die Zentraleinheit 200 zu übertragende digitale Signale gewandelt werden. Wie bereits erwähnt, wird dabei der MOSFET 110 gesperrt und somit das Solarzellenmodul 500 spannungsmäßig aus dem Verbund mit den anderen Einheiten der Photovoltaikanlage herausgelöst, sofern im Ergebnis dieser Messungen das Bestehen eines Überstroms oder einer Unterspannung erkannt wird. Im letztgenannten Fall wird der MOSFET 110 durch die Komponente 117 (Unterspannungsunterbrechung - UVLO = Under Voltage Logout) gesperrt. In diesem Falle wird, wie schon ausgeführt, der Stringstrom durch die andernfalls sperrende Bypassdiode 109 übernommen. Bestandteil des bereits erwähnten Analog-Digital-Wandlers 116 ist zudem eine Prüf- und Messkomponente 115, nämlich ein Temperatursensor. Mittels dieses Temperatursensors werden die Umgebungstemperatur des zugehörigen Solarzellenmoduls 500 und die Leiterplattentemperatur der Sicherheitsschalteinheit 100 (und damit im Falle einer als integrierte Einheit ausgebildeten Sicherheitsschalteinheit auch die Leiterplattentemperatur der Anschlussbox des Solarzellenmoduls) überwacht, mit der Möglichkeit, das Solarzellenmodul 500 im Falle eventueller Überhitzung abzuschalten, das heißt es spannungsmäßig aus der Photovoltaikanlage herauszulösen. Demnach ist es hierdurch möglich, eine eventuelle Brandgefahr frühzeitig zu erkennen und hierauf mit einer Abschaltung der Photovoltaikanlage beziehungsweise ihrer Teile zu reagieren sowie gegebenenfalls, soweit diese Gefahr eventuell auf eine Fehlfunktion des Solarzellenmoduls 500 oder der Sicherheitsschalteinrichtung 100 selbst zurückgeht, auch das Entstehen von Bränden zu verhindern. Die mittels des Temperatursensors ermittelten Temperaturen werden vorzugsweise an die Zentraleinheit 200 übermittelt und dort in einer Log-Datei gespeichert. In dem dargestellten Ausführungsbeispiel ist der Temperatursensor dazu über eine Schnittstelle 122 an eine separate serielle Bus-Leitung angeschlossen. An diese serielle Bus-Leitung können bis zu 255 Temperatursensoren entsprechender Solarzellenmodule mit zugehörigen Sicherheitsschalteinheiten 100 angekoppelt werden, welche über eine Binäradresse adressiert und voneinander unterschieden werden. Über den entsprechenden Zweidraht-Bus werden dabei bidirektional sowohl Adressen und Messdaten übertragen als auch die einzelnen, als aktive Elemente ausgebildeten Temperatursensoren mit Spannung versorgt.

Durch die Belastungskomponente 118 und die Komponente beziehungsweise den MOSFET 119 kann das Solarzellenmodul 500 in einem Testbetrieb mit einer definierten impulsförmigen Belastung - daher auch als Impulsbetrieb bezeichnet - betrieben werden, wobei das Solarzellenmodul 500 bei dem entsprechenden, vorzugsweise nur für einige Millisekunden eingenommenen Testbetrieb durch Sperren des MOSFET 110 jeweils kurzzeitig aus dem Verbund mit den anderen Einheiten der Photovoltaikanlage herausgelöst, aber gleichzeitig über die Bypassdiode 109 überbrückt wird. Die Prüf- und Messkomponenten 113, 114 und 125 dienen der Messung von Strom- und Spannungswerten sowie der Messung des Innenwiderstandes des zugehörigen Solarzellenmoduls 500 im Impulsbeziehungsweise Testbetrieb. Dabei wird im Wege einer mittels der Komponente 126 erfolgenden Spannungsmessung sichergestellt, dass der Impulsbetrieb nicht aktiviert wird, sofern die von dem Solarzellenmodul gelieferte Spannung einen Wert von 10 V unterschreitet. Sowohl die im laufenden Betrieb als auch die im Testbetrieb ermittelten Strom- und Spannungswerte sowie die gemessenen Temperaturwerte werden, veranlasst durch den Mikrocontroller 104 des Funkmoduls 103 vorzugsweise über dessen Funksende- und Empfangskomponente 120 (HF), an die Zentraleinheit 200 übermittelt. Die von beziehungsweise mit den entsprechenden Prüf- und Messkomponenten 111, 112, 113, 114, 115 , 125 erfassten Strom-, Spannungs- und/oder Temperaturwerte werden durch den Mikrocontroller vorverarbeitet und in Form standardisierter Protokolle an die Zentraleinheit 200 übertragen, wobei Bestandteil der nach entsprechenden Protokollen übertragenen Daten ein Zeitstempel ist, der Datum und Uhrzeit der Erfassung des jeweiligen Messwertes angibt. Das Datum und die Uhrzeit werden durch die Zeitkomponente 123 bereitgestellt.

Über eine Standard-Programmierschnittstelle 121 (SPI) kann der Mikrocontroller 104 programmiert und damit die Sicherheitsschalteinheit 100 zum Beispiel im Hinblick auf Spannungs- und/oder Stromwerte für das Durchschalten und Sperren des MOSFET 110 und den Ablauf sowie die Testbedingungen im Testbetrieb konfiguriert werden. Darüber hinaus sind eine entsprechende Konfigurierung der Sicherheitsschalteinheit 100 oder ein vollständiges Update der durch ihren Mikrocontroller 104 verarbeiteten Software aber auch über Funk, (gegebenenfalls auch über das Internet - WLAN) unter Nutzung der Funksende- und Empfangskomponente 120 möglich.

In der Fig. 1a ist der in der Fig. 1 gezeigte Teil der erfindungsgemäßen Sicherheitseinrichtung zur Verdeutlichung der Sachverhalte bezüglich der durch die Sicherheitsschalteinheit 100 ermöglichten spannungsmäßigen Auftrennung des Verbundes des zugehörigen Solarzellenmoduls 500 mit den anderen Einheiten der Photovoltaikanlage nochmals in Form eines vereinfachten Blockschaltbildes dargestellt. Der betreffende Teil der Sicherheitseinrichtung ist dabei zur besseren Veranschaulichung in seiner Einordnung in einen String 30 (siehe hierzu auch Fig.4) mit einem in gleicher Weise mit einer Sicherheitsschalteinheit beschalteten weiteren Solarzellenmodul gezeigt. In diesem Zusammenhang ist außerdem für das Solarzellenmodul 500 ein in der Praxis gebräuchliches Ersatzschaltbild dargestellt.

Wie aus der Abbildung zu erkennen ist, ist bei dem in der Figur oben dargestellten Schaltungsteil das Solarzellenmodul 500, durch die zugehörige Sicherheitsschalteinheit 100, gerade aus dem Verbund mit dem anderen unten dargestellten, in gleicherweise ausgebildeten Schaltungsteil und damit aus dem Verbund mit dem String 30 spannungsmäßig herausgelöst. Dennoch fließt aufgrund der von dem nicht spannungsmäßig aus dem String 30 herausgelösten Solarzellenmodul des anderen (unteren) Schaltungsteils bereitgestellten Klemmspannung weiterhin ein Stringstrom. Im Bereich des oberen Schaltungsteils mit dem insbesondere mittels des in diesem Falle sperrenden MOSFET 110 der Sicherheitsschalteinheit 100 spannungsmäßig aus dem String 30 herausgelösten Solarzellenmodul 500 fließt dieser Strom zwischen den Punkten X, Y, wie in der Figur zur Verdeutlichung hervorgehoben über die Bypassdiode 109. In dem unteren Schaltungsteil, dessen Solarzellenmodul nicht spannungsmäßig aus dem String 30 herausgelöst ist, fließt er hingegen durch das entsprechende Solarzellenmodul und den hier geöffneten beziehungsweise durchgeschalteten MOSFET der zugehörigen Sicherheitsschalteinheit. Der MOSFET weist, wie in der von der gestrichelten Linie umgebenen Einzelheit angedeutet, in der Praxis zwischen Drain und Source eine Diode auf, welche ihn beim Übergang in den gesperrten Zustand vor Zerstörung durch Spannungsüberhöhungen schützt, wie sie insbesondere bei induktiven Lasten auftreten. Alternativ kann, wie ebenfalls angedeutet, der durch ein Symbol dargestellte MOSFET 110 aber auch durch die Kombination eines NMOS- mit einem PMOS Leistungs-MOSFET realisiert sein, bei welcher die Dioden der bezüglich ihrer Gates entsprechend zu beschaltenden Transistoren gegenpolig geschaltet sind, so dass bei gesperrten MOSFET 110 in jedem Falle ein Rückstrom unterbunden wird.

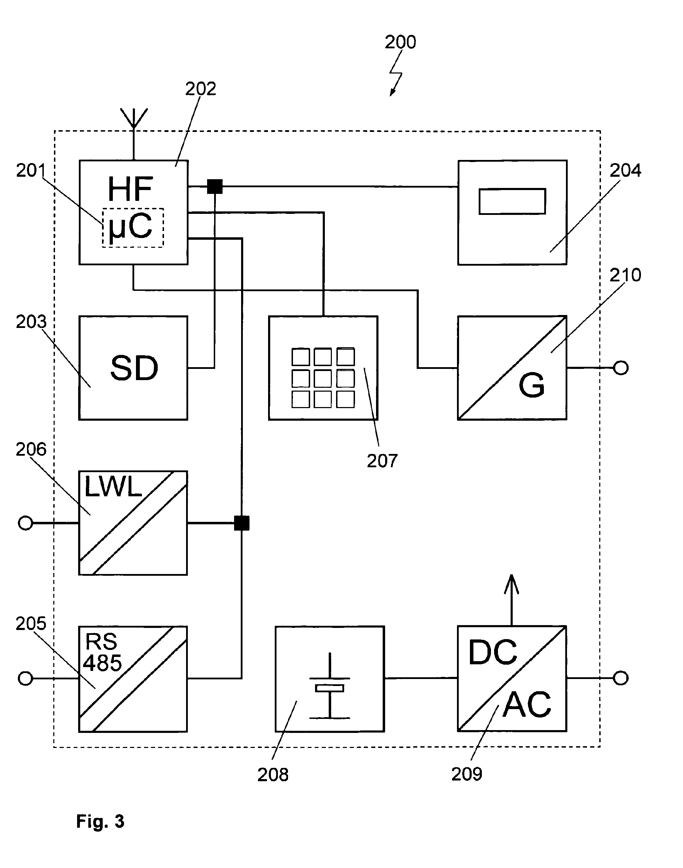

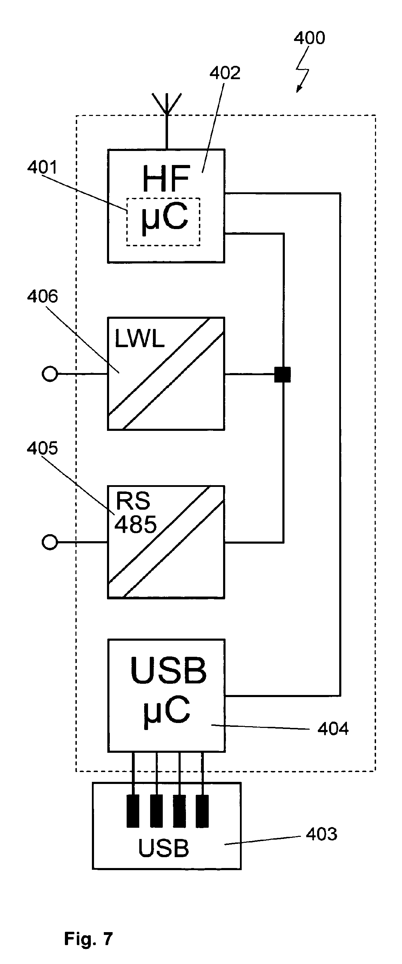

Die Fig. 3 zeigt ein grobes Blockschaltbild für eine mögliche Ausbildungsform der Zentraleinheit 200 der erfindungsgemäßen Sicherheitseinrichtung. Die entsprechende Zentraleinheit 200 ist vorzugsweise über Funk, gegebenenfalls aber unter Nutzung der Schnittstellen 205, 206 auch über einen Lichtwellenleiter oder drahtgebunden mit den Sicherheitsschalteinheiten 100 der Solarzellenmodule 500 in Verbindung. Bei der Zentraleinheit 200 kann es sich beispielsweise um einen handelsüblichen PC oder, wie hier, um eine einfachere Steuer- und Verarbeitungseinheit handeln. Denkbar ist es aber auch, dass die Zentraleinheit 200 als Teil einer gegebenenfalls ohnehin vorhandenen Störmeldezentrale oder einer Notruf- beziehungsweise Brandmeldezentrale ausgebildet oder auf eine solche Zentrale aufgeschaltet ist. Vorliegend ist auch hier ein für die Steuerung und Verarbeitung von Messdaten vorgesehener Prozessor beziehungsweise Mikrocontroller 201 (µC) als Bestandteil eines Funkmoduls 202 ausgebildet, wobei dem Mikrocontroller 201 eine SD-Speicherkarte 203 zugeordnet ist. Derartige Funkmodule 202 mit einer integrierten Verarbeitungseinheit beziehungsweise einem Prozessor oder Mikrocontroller 201 sind als gängige Produkte auf dem Markt erhältlich. Die Zentraleinheit 200 verfügt, wie ersichtlich, ferner über eine beispielsweise als LCD-Display ausgebildete Anzeigekomponente 204 und ein Bedienfeld 207 beziehungsweise eine Bedientastatur. Bei Letzterer handelt es sich beispielsweise um ein einfaches Tastenfeld mit den Tasten mehr oder weniger fest zugeordneten Funktionen, über welches beispielsweise auch die Sicherheitsschalteinheiten 100 der Solarzellenmodule 500 im Wege einer binären Adressierung angesprochen und gegebenenfalls abgeschaltet beziehungsweise aus dem Verbund mit den anderen Einheiten der Photovoltaikanlage spannungsmäßig getrennt werden können. Die Zentraleinheit 200 wird durch den Anschluss an die Netzspannung 208 oder alternativ beziehungsweise wahlweise durch einen Akkumulator 209 versorgt. Sie verfügt ferner über ein Gateway 210, über welches sie beispielsweise über das Internet (Zugang über LAN oder WLAN) oder über ein Mobilfunknetz von entfernter Stelle ansprechbar ist, an einen Feldbus, wie den aus der Verbrauchsdatenerfassung bekannten M-Bus oder den aus der Automatisierungstechnik bekannten Profibus (Process Field Bus) angeschlossen oder mit einem USB-Gerät, wie dem in der Fig. 7 dargestellten USB-Funkmodul 400, verbunden werden kann. Hierdurch ist es möglich, in der Zentraleinheit 200 gespeicherte Daten, welche von ihr zuvor von den Sicherheitsschalteinheiten 100 empfangen wurden, auszulesen und gegebenenfalls, beispielsweise über das Internet, die Zentraleinheit 200 zu konfigurieren.

Die Fig. 4 zeigt die Prinzipdarstellung einer mehrere Strings 30 mit Solarzellenmodulen 500 aufweisenden Photovoltaikanlage. Die einzelnen Strings 30 sind, wie aus der Praxis bekannt, an einem Wechselrichter 10 zusammengeführt, über welchen der von ihnen gelieferte Strom in das Netz eingespeist wird. Erfindungsgemäß ist jedes der Solarzellenmodule 500 mit einer zugehörigen Sicherheitsschalteinheit 100 beschaltet, welche wie ersichtlich, als integrale Einheit (i = iSSUP) in die Anschlussbox des jeweiligen Solarzellenmoduls eingefügt oder als externe Einheit (e = eSSUP) aufgesteckt sein kann. In dem gezeigten Beispiel sind die Sicherheitsschalteinheiten 100 untereinander und mit der Zentraleinheit 200 über einen als Zweidraht-Ringbus 20 ausgeführten Bus verbunden. Der Zweidraht-Ringbus 20 (auch Loop-Bus genannt) gewährleistet die Kommunikation in zwei Richtungen so, dass eine Unterbrechung oder ein Kurzschluss der Ring-Leitung in einem Punkt nicht zu einem Ausfall der gesamten Kommunikation zwischen den Einheiten 100, 200, 300 der erfindungsgemäßen Sicherheitseinrichtung führt. Bei der in der Prinzipdarstellung gezeigten Anlage ist außerdem zwischen jedem String 30 und dem Wechselrichter 10 eine zusätzliche, ebenfalls mit der Zentraleinheit 200 in Verbindung stehende, im Weiteren auch als Kurzschluss-Schalteinheit 300 bezeichnete Schalteinheit angeordnet. Diese Kurzschluss-Schalteinheit 300 dient dazu, im Falle der Abschaltung eines Strings 30 beziehungsweise aller seiner Solarzellenmodule 500, was aufgrund einer Strom- und/oder Spannungsmessung innerhalb dieser zusätzlichen Kurzschluss-Schalteinheit 300 erkannt wird, oder im Falle einer Alarmabschaltung aller Strings 30 den jeweiligen String 30 beziehungsweise alle Strings vorsorglich zusätzlich kurzzuschließen. Hierdurch ist dann, so zusagen mit doppelter Sicherheit, gewährleistet, dass von der Anlage, beispielsweise im Brandfall, absolut keinerlei Gefahr mehr durch hohe Spannungen und Ströme ausgeht.

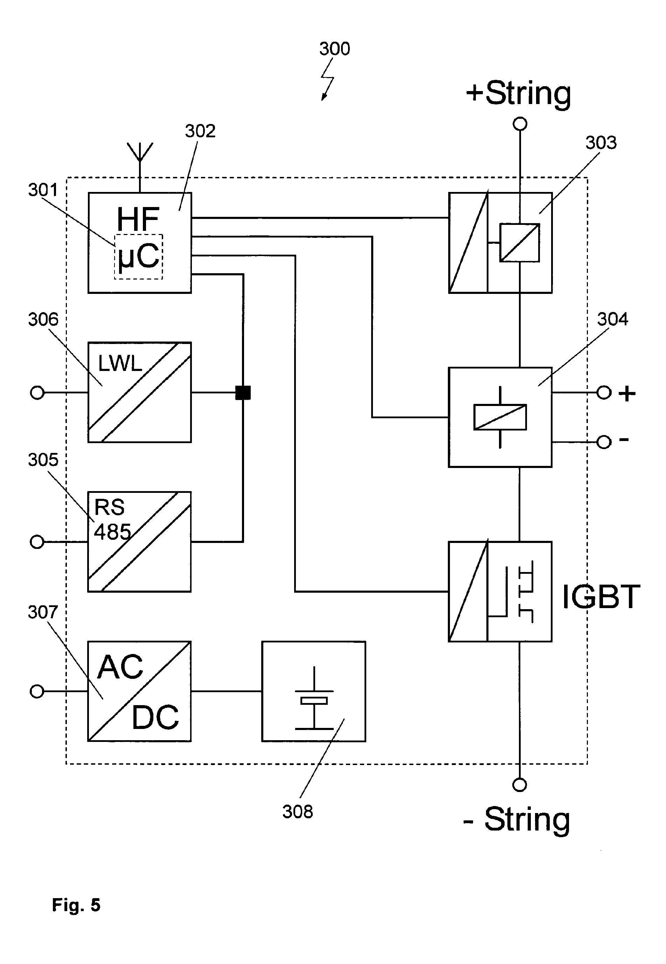

Die Fig. 5 zeigt ein Blockschaltbild einer möglichen Ausbildungsform einer solchen Kurzschluss-Schalteinheit 300, wie sie gemäß Fig. 4 zwischen einem String 30 und dem Wechselrichter 10 eingefügt ist. Bestandteil der über eine Schnittstelle 305 oder 306 eingebundenen Kurzschluss-Schalteinheit 300 ist ein Element 303 zur Stromüberwachung, durch welches festgestellt wird, wenn von dem mit ihm verbundenen String 30 kein Strom mehr geliefert wird, also der Stringstrom den Wert 0 annimmt. In diesem Falle ist von einer Störung oder Abschaltung des entsprechenden Strings 30 auszugehen und das dargestellte Schaltelement 304 schließt den betreffenden String 30 vorsorglich zusätzlich kurz, damit nicht gegebenenfalls im Falle von Reparaturarbeiten unbeabsichtigt eventuell doch wieder eine Spannung an dem String 30 ansteht, welche das Fließen eines eventuell lebensgefährlichen Stringstroms zur Folge haben kann. Die Kurzschluss-Schalteinheit 300 wird ebenso wie die Zentraleinheit 200 über den Anschluss an die Netzspannung 307 und/oder durch einen Akkumulator 308 versorgt. Über das mit einem Mikrocontroller 301 (µC) ausgestattete Funkmodul 302 ist die Kurzschluss-Schalteinheit 300 steuerbar und gibt ihrerseits an die Zentraleinheit 200 jeweils eine Rückmeldung über die von ihr eingenommenen Schaltzustände.

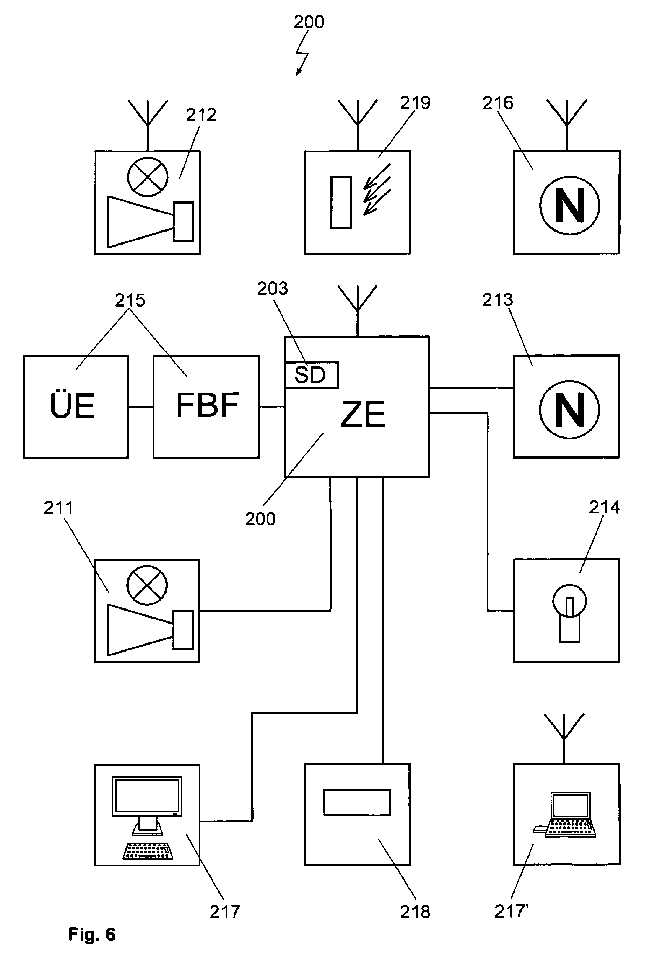

In der Fig. 6 ist die Zentraleinheit 200 im Hinblick auf ihre Einbeziehung eine mögliche Topologie eines übergeordneten Systems dargestellt. Hier ist zu erkennen, dass die Zentraleinheit 200 unmittelbar am Ort ihrer Anordnung durch einen optischen und/oder akustischen Signalgeber 211, beispielsweise das Bestehen von Gefahrenzuständen signalisieren kann. Ferner ist die Signalisierung an entfernter Stelle über ein entsprechendes Funkmodul ermöglicht, dessen Signale gegebenenfalls an der entfernten Stelle ebenfalls auf einen optischen und/oder akustischen Signalgeber 212 geführt werden. Vor Ort ist über einen mit der Zentraleinheit 200 verbundenen Nottaster 213 eine Abschaltung aller Solarzellenmodule der Photovoltaikanlage (Notabschaltung) ermöglicht. Ferner ist es vorgesehen, dass für die Einsatzkräfte der Feuerwehr in einem verschließbaren Gehäuse 214 eine ebenfalls mit der Zentraleinheit 200 verbundene Bedieneinheit für die Zentraleinheit 200 und damit für die erfindungsgemäße Sicherheitseinrichtung angeordnet ist. Außerdem ist eine Komponente zur Fernabschaltung 216 per Funk zur Nutzung durch ein Reparatur- und/oder Wartungsunternehmen vorgesehen. Gemäß der dargestellten Topologie ist die Zentraleinheit 200 zusätzlich auf eine bei einer Notrufabfragestelle 215 der Feuerwehr geführte Notrufleitung aufgeschaltet. Über ein beziehungsweise mehrere Gateways 217, 217' ist es darüber hinaus möglich, wie bereits ausgeführt, die Zentraleinheit 200 mittels PC oder Laptop über das Internet anzusprechen oder an diese ein USB-Funkmodul 400 gemäß Fig. 7 anzuschließen, mittels welchem Messwerte aus der Zentraleinheit 200 ausgelesen und an eine andere Einheit, gegebenenfalls auch an entfernter Stelle, übertragen werden können. Zu Kontroll- und oder Informationszecken ist gemäß dem dargestellten Ausführungsbeispiel zudem eine gegenüber der Zentraleinheit 200 abgesetzte, beispielsweise im Treppenhaus oder der Außenwand eines Gebäudes angeordnete Anzeige 218 vorgesehen. Der Lichtsensor 219 ist zur Feststellung der jeweiligen Lichtverhältnisse vorgesehen, bei denen insbesondere Strom- und Spannungswerte der Solarzellenmodule 500 gemessen beziehungsweise geprüft werden, da diese nur im Zusammenhang mit der Kenntnis der jeweiligen Messbedingungen, also insbesondere der Lichtbedingungen wirklich aussagekräftig sind.

Das zuvor erwähnte USB-Funkmodul 400 ist in der Fig. 7 in einem Blockschaltbild dargestellt. Dieses ist demnach so ausgeführt, dass es an einen USB-Anschluss der Zentraleinheit 200 der erfindungsgemäßen Sicherheitseinrichtung ansteckbar ist. Die über die USB-Schnittstelle 403 (mit USB-Treiber und Mikrocontroller 404) ausgelesenen Daten werden dann entweder über ein im Beispiel mit einem Mikrocontroller 401 ausgestattetes Funkmodul 402 an einen Laptop oder eine Einheit an entfernter Stelle weitergeleitet oder aber wahlweise einer anderen Einheit, beispielsweise einem PC oder Laptop, über eine RS485-Schnittstelle 405, einen Lichtwellenleiteranschluss 406 oder die zwischenzeitlich von der Zentraleinheit getrennte USB-Schnittstelle 403 zur Verarbeitung gestellt.

Liste der Bezugszeichen
- 10: Wechselrichter
- 20: Bus
- 30: String
- 100: Sicherheitsschalteinheit
101, 102 Komponente (für Spannungserzeugung)
103 Funkmodul
104 Mikrocontroller
105, 106 Schnittstelle
107 Überspannungsschutzeinrichtung
108, 109 Bypassdiode
110 MOSFET
111, 112 Prüf- und Messkomponente (Strom)
113, 114 Prüf- und Messkomponente (Strom)
115 Prüf- und Messkomponente (Temperatur)
116 Analog-Digital-Wandler
117 Unterspannungsunterbrechung
118 Belastungseinheit
119 MOSFET
120 Funksende- und Empfangskomponente
121 Standard-Programmierschnittstelle
122 Schnittstelle (für Temperatursensor)
123 Zeitkomponente
124 (Puffer-) Kondensator
125 Prüf- und Messkomponente (Spannung)
126 (Spannnungsmess-) Komponente
- 200: Zentraleinheit
201 Mikrocontroller
202 Funkmodul
203 Speicherkarte
204 Anzeigekomponente
205, 206 Schnittstelle
207 Bedienfeld
208 Netzspannungsversorgung
209 Akkumulator
210 Gateway
211, 212 Signalgeber
213 Nottaster
214 verschließbares Gehäuse
215 Notrufabfragestelle
216 Fernabschaltung
217, 217' Gateway
- 300: Kurzschluss-Schalteinheit
301 Mikrocontroller
302 Funkmodul
303 Element zur Stromüberwachung
304 Schaltelement
305, 306 Schnittstelle
307 Netzspannungsversorgung
308 Akkumulator
- 400: USB-Funkmodul
401 Mikrocontroller
402 Funkmodul
403 USB-Schnittstelle
404 USB-Treiber und Mikrocontroller
405, 406 Schnittstelle

## Patentansprüche

1. Sicherheitseinrichtung für eine Photovoltaikanlage, wobei die Photovoltaikanlage mindestens ein aus einer Mehrzahl von Solarzellen (501₁ - **501ₙ)** und einer Anschlussbox (502) bestehendes Solarzellenmodul (500) aufweist, welches über seine Anschlussbox (502) mit mindestens einer anderen Einheit der Photovoltaikanlage verbunden ist, **dadurch gekennzeichnet, dass**
a.) die Sicherheitseinrichtung mindestens aus jeweils einer Sicherheitsschalteinheit (100) je Solarzellenmodul (500) der Photovoltaikanlage und aus mindestens einer, mit einer oder mehreren Sicherheitsschalteinheiten (100) in Verbindung stehenden Zentraleinheit (200) besteht, wobei jede Sicherheitsschalteinheit (100) der betreffenden Photovoltaikanlage mit einer Zentraleinheit (200) in Verbindung steht,
b.) das jeweils eine Sicherheitsschalteinheit (100) in die Anschlussbox (502) eines jeweiligen Solarzellenmoduls (500) integriert oder als Aufsteckmodul in die über die Anschlussbox (502) gegebene Verbindung des betreffenden Solarzellenmoduls (500) mit der mindestens einen anderen Einheit der Photovoltaikanlage einschleifbar ist,
c.) jede Sicherheitsschalteinheit (100) zur Einnahme unterschiedlicher Schaltzustände ausgebildet ist, wobei in mindestens einem dieser Schaltzustände das zugehörige Solarzellenmodul (500) unter spannungsmäßiger Auftrennung des Verbunds mit anderen Einheiten der Photovoltaikanlage, nicht aber der Verbindung seiner Sicherheitsschalteinheit (100) mit der entsprechenden Zentraleinheit (200), überbrückt ist,
d.) eine jeweilige Sicherheitsschalteinheit (100) zur Einnahme eines den Verbund des zugehörigen Solarzellenmoduls (500) mit anderen Einheiten der Photovoltaikanlage spannungsmäßig auftrennenden Schaltzustandes durch die mit ihr in Verbindung stehende Zentraleinheit (200) veranlasst wird und/oder sie der betreffenden Zentraleinheit (200) die Einnahme dieses Schaltzustandes über die bestehende Verbindung signalisiert.

2. Sicherheitseinrichtung nach Anspruch 1, **dadurch gekennzeichnet, dass** die Sicherheitsschalteinheit oder Sicherheitsschalteinheiten (100) die zu ihrem Betrieb erforderlichen Spannungswerte aus der vom zugehörigen Solarzellenmodul (500) bereitgestellten Spannung gewinnen.

3. Sicherheitseinrichtung nach Anspruch 1 oder 2, **dadurch gekennzeichnet, dass** die Sicherheitsschalteinheit oder Sicherheitsschalteinheiten (100) eine Komponente (119) umfassen, durch welche an einem aus dem Verbund mit anderen Einheiten der Photovoltaikanlage getrennten Solarzellenmodul durch Lichteinfall entstehende Spannungen kurzgeschlossen werden.

4. Sicherheitseinrichtung nach einem der Ansprüche 1 bis 3 für eine Photovoltaikanlage mit mehreren Solarzellenmodulen (500), **dadurch gekennzeichnet, dass** diese zusätzliche, ebenfalls mit einer Zentraleinheit (200) in Verbindung stehende Kurzschluss-Schalteinheiten (300) zum Kurzschließen von durch jeweils mehrere in Reihe geschaltete Solarzellenmodule (500) gebildeten Strings (30) umfasst.

5. Sicherheitseinrichtung nach einem der Ansprüche 1 bis 4, **dadurch gekennzeichnet, dass** die Sicherheitsschalteinheit oder Sicherheitsschalteinheiten (100) eine oder mehrere Prüf- und Messkomponenten (111, 112, 113, 114, 125) zur Messung und/oder Überwachung von zumindest Strom- und Spannungswerten des zugehörigen Solarzellenmoduls (500) umfassen, deren Messdaten an die mit der jeweiligen Sicherheitsschalteinheit (100) verbundene Zentraleinheit (200) übermittelt werden.

6. Sicherheitseinrichtung nach Anspruch 5, **dadurch gekennzeichnet, dass** die Sicherheitsschalteinheit oder Sicherheitsschalteinheiten Prüf- und Messkomponenten (115) mit zugehörigen Sensoren zur Erfassung der Solarzellentemperatur innerhalb des jeweiligen Solarzellenmoduls (500) und/oder der Umgebungstemperatur umfassen.

7. Sicherheitseinrichtung nach Anspruch 5 oder 6, **dadurch gekennzeichnet, dass** die Sicherheitsschalteinheit oder Sicherheitsschalteinheiten (100) mit einem Mikroprozessor oder einem Mikrokontroller (104) ausgestattet sind, durch den eine Vorverarbeitung der mittels der Prüf- und Messkomponenten (111, 112, 113, 114, 115, 125), erfassten Mess- und Prüfdaten und eine Übertragung der vorverarbeiteten Daten zusammen mit einem das Datum und die Uhrzeit ihrer Erhebung umfassenden digitalen Zeitstempel an die mit der jeweiligen Sicherheitsschalteinheit (100) verbundene Zentraleinheit (200) nach standardisiertem Datenübertragungsprotokoll erfolgt.

8. Sicherheitseinrichtung nach einem der Ansprüche 5 bis 7, **dadurch gekennzeichnet, dass** die Sicherheitsschalteinheit oder Sicherheitsschalteinheiten (100) zur Einnahme eines Schaltzustandes ausgebildet sind, in dem das zugehörige Solarzellenmodul (500) in einem Testbetrieb betrieben wird, wobei für einige Millisekunden der Verbund des betreffenden Solarzellenmoduls (500) mit den anderen Einheiten der Photovoltaikanlage spannungsmäßig aufgetrennt und mittels der Prüf- und Messkomponente oder Prüf- und Messkomponenten (111, 112, 113, 114, 115, 125) Parameter des Solarzellenmoduls (500), wie dessen Klemmspannung unter definierten Lastbedingungen, seine Leerlaufspannung, sein Kurzschlussstrom und/oder sein Innenwiderstand ermittelt werden.

9. Sicherheitseinrichtung nach einem der Ansprüche 1 bis 8, **dadurch gekennzeichnet, dass** die Zentraleinheit oder Zentraleinheiten (200) einen Nottaster (213, 214, 216) aufweisen, bei dessen Betätigung alle Solarzellenmodule (500) aus dem Verbund mit anderen Einheiten der Photovoltaikanlage spannungsmäßig getrennt und gegebenenfalls die an ihnen entstehenden Spannungen durch eine in der jeweils zugehörigen Sicherheitsschalteinheit (100) angeordnete Komponente (119) und/oder alle durch Reihenschaltung mehrerer Solarzellenmodule (500) gebildeten Strings (30) jeweils durch eine dafür vorgesehene Kurzschluss-Schalteinheit (300) kurzgeschlossen werden.

10. Sicherheitseinrichtung nach einem der Ansprüche 1 bis 9, **dadurch gekennzeichnet, dass** die Zentraleinheit oder Zentraleinheiten (200) eine Tastatur (207) zu ihrer Bedienung und Konfiguration sowie zur Steuerung der mit ihr in Verbindung stehenden Sicherheitsschalteinheiten (100) aufweisen.

11. Sicherheitseinrichtung nach einem der Ansprüche 1 bis 10, **dadurch gekennzeichnet, dass** die Zentraleinheit oder Zentraleinheiten (200) über eine Internetverbindung von entfernter Stelle bedienbar und/oder konfigurierbar sind.

12. Sicherheitseinrichtung nach einem der Ansprüche 1 bis 11, **dadurch gekennzeichnet, dass** die Zentraleinheit oder Zentraleinheiten (200) neben einer Anzeigekomponente (204) zur Anzeige von Betriebszuständen und gegebenenfalls Messwerten der Solarzellenmodule Mittel (211, 212) zur optischen und/oder akustischen Signalisierung von Störungen oder Gefahrenzuständen umfassen, welche unmittelbar an einem mit der Photovoltaikanlage ausgestatteten Gebäude und/oder an entfernter Stelle angeordnet sind.

13. Sicherheitseinrichtung nach einem der Ansprüche 1 bis 12, **dadurch gekennzeichnet, dass** die Zentraleinheit oder Zentraleinheiten (200) ein Aufschaltmodul umfassen, über welches im Falle eines Brandes ein Notruf an eine Notrufabfragestelle (215) der Feuerwehr übertragen wird.

14. Sicherheitseinrichtung nach einem der Ansprüche 1 bis 13, **dadurch gekennzeichnet, dass** die Verbindung zwischen der oder den Sicherheitsschalteinheiten (100) und der jeweiligen Zentraleinheit (200) als Funkverbindung ausbildet ist.

15. Sicherheitseinrichtung nach einem der Ansprüche 1 bis 13, mit mehreren Sicherheitsschalteinheiten (100) **dadurch gekennzeichnet, dass** die Sicherheitsschalteinheiten (100) untereinander und mit der jeweiligen Zentraleinheit (200) über einen elektrischen oder optischen Bus (20) verbunden sind.
